# DEMANDE DE BREVET EUROPEEN

(11) **EP 1 385 012 A1**
(43) Date de publication de la demande: **28.01.2004**
(21) Numéro de dépôt: 02291817.1
(22) Date de dépôt: 18.07.2002
(51) Int. Cl.: G01R 15/12

(54) **Appareil multimètre à dispositif de sélection tactile**

(71) Demandeur: Chauvin, Arnoux, 75018 Paris (FR)
(72) Inventeur: Arnoux, Daniel, 44500 La Baule (FR); Arnoux, Axel, 75015 Paris (FR); Genter, Claude, 92200 Neuilly sur Seine (FR)
(74) Mandataire: Thinat, Michel

(57) **Abrégé**

L'invention concerne un appareil multimètre de mesure d'une pluralité de grandeurs, telles que l'intensité ou la tension d'un courant électrique ou la résistance électrique d'un circuit, l'appareil comprenant une pluralité de moyens de mesure associé chacun à une grandeur prédéterminée, et un dispositif de sélection (20) de la grandeur à mesurer.

Selon l'invention, le dispositif de sélection (20) comprend des zones tactiles (21) de sélection de la grandeur à mesurer, et des moyens d'activation des moyens de mesure associés à la grandeur sélectionnée à l'aide des zones tactiles de sélection (21).

## Description

L'invention concerne en général les appareils multimètres, notamment les appareils portables de mesure d'une pluralité de grandeurs, telles que l'intensité ou la tension d'un courant électrique ou la résistance électrique d'un circuit

Plus précisément, l'invention concerne un appareil multimètre de mesure d'une pluralité de grandeurs, telles que l'intensité ou la tension d'un courant électrique ou la résistance électrique d'un circuit, l'appareil comprenant une pluralité de moyens de mesure associé chacun à une grandeur prédéterminée, et un dispositif de sélection de la grandeur à mesurer.

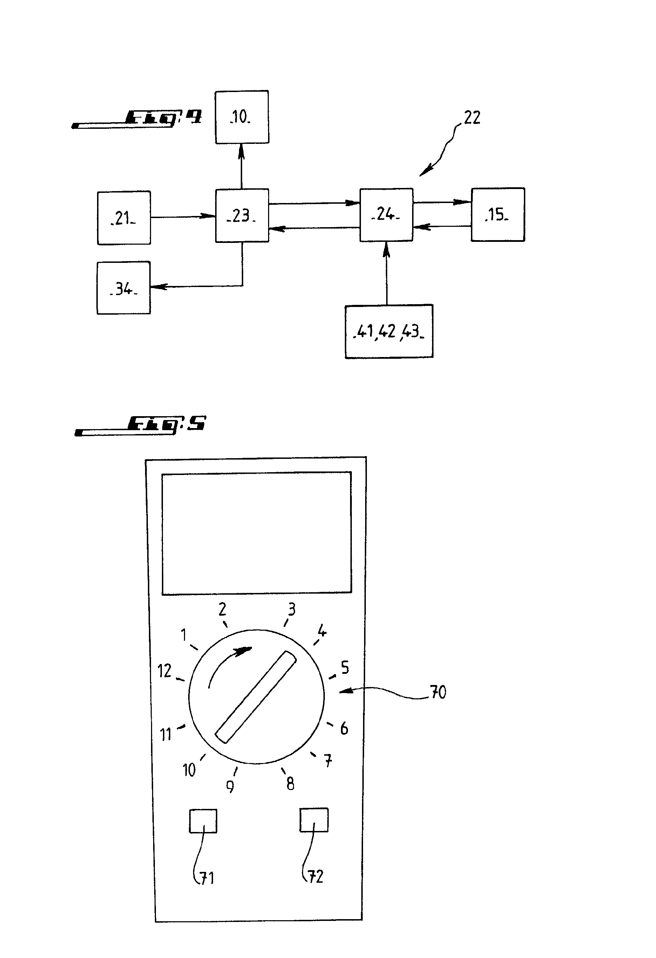

Des dispositifs de ce type sont connus de l'art antérieur, et sont notamment employés par les électriciens. L'un de ces dispositifs est représenté sur la figure 5.

Le dispositif de sélection de la grandeur à mesurer est généralement un sélecteur rotatif mécanique disposé en façade de l'appareil, permettant de sélectionner la grandeur, et, pour chaque grandeur, le calibre de mesure.

Le sélecteur rotatif présente typiquement 11 positions définies par des crans d'arrêt du sélecteur, accessibles successivement en tournant le sélecteur dans un sens obligatoire à partir d'une position d'arrêt.

La qualité de ce sélecteur est un des éléments importants d'appréciation du multimètre par l'utilisateur.

Les sélecteurs rotatifs mécaniques s'usent rapidement, sous l'effet du déplacement et du frottement des balais sur les contacts électriques. Il en résulte une usure des balais, des contacts, et de la cage dans laquelle tourne le sélecteur. Ces usures combinées provoquent une dérive des mesures à terme, due à l'effet de résistance des contacts et aux dépôts métalliques sur les circuits imprimés.

Dans ce contexte, la présente invention a pour but de pallier les défauts mentionnés ci-dessus.

A cette fin, le dispositif de l'invention, par ailleurs conforme à la définition générique qu'en donne le préambule ci-dessus, est essentiellement caractérisé en ce que le dispositif de sélection comprend des zones tactiles de sélection de la grandeur à mesurer, et des moyens d'activation des moyens de mesure associés à la grandeur sélectionnée à l'aide des zones tactiles de sélection.

Dans un mode de réalisation possible de l'invention, les moyens d'activation comprennent un microprocesseur, chaque zone tactile de sélection positionnant un relais statique ou électromécanique pour agir sur le microprocesseur.

Avantageusement, l'appareil peut comprendre une pluralité de douilles d'entrée et les moyens d'activation peuvent comprendre un circuit de commutation reliant les douilles d'entrée aux moyens de mesure et dont la configuration est pilotée par le microprocesseur en fonction des commandes reçues des zones tactiles de sélection.

Par exemple, les grandeurs peuvent être subdivisées en plusieurs familles, les zones tactiles de sélection comprenant des zones tactiles de famille permettant de sélectionner une famille de grandeurs, et des zones tactiles menu permettant de sélectionner une grandeur au sein d'une famille.

De préférence, l'appareil peut comprendre des moyens de mesure de l'intensité électrique, une pluralité de douilles d'entrée dont une douille d'entrée Ampère utilisée au moins quand les moyens de mesure d'intensité sont sélectionnés, un cordon de mesure sélectivement connecté par une extrémité de connexion à l'une des douilles, et des moyens de détection de la connexion de l'extrémité de connexion du cordon à la douille d'entrée Ampère.

Avantageusement, la douille d'entrée Ampère peut comprendre deux demi-douilles électriquement isolées l'une de l'autre, l'extrémité de connexion du cordon étant équipée d'une fiche mettant les deux demi-douilles en court-circuit quand l'extrémité de connexion du cordon est connectée à la douille d'entrée Ampère, les moyens de détection détectant la mise en court-circuit des deux demi-douilles.

Par exemple, les moyens d'activation peuvent activer automatiquement les moyens de mesure de l'intensité à la condition que les moyens de détection détectent la connexion de l'extrémité de connexion du cordon à la douille d'entrée Ampère et que l'intensité ait été sélectionnée à l'aide du dispositif de sélection de la grandeur à mesurer.

De préférence, une des deux demi-douilles de la douille d'entrée Ampère peut être électriquement reliée à une douille d'entrée de référence à travers un fusible principal et un fusible secondaire en série, le fusible secondaire se détruisant à une tension au moins deux fois plus faible que le fusible principal.

Avantageusement, les zones tactiles de famille peuvent être disposées sur un cercle.

Par exemple, l'appareil peut comprendre des indicateurs lumineux, disposés en cercle à proximité des zones tactiles de famille, indiquant à quelle famille appartient le moyen de mesure actif.

D'autres caractéristiques et avantages de l'invention ressortiront clairement de la description qui en est faite ci-dessous, à titre indicatif et nullement limitatif, en référence aux figures annexées, parmi lesquelles :
- la figure 1 est une vue de face de l'appareil de l'invention, sans son cordon de mesure,
- la figure 2 est un schéma de principe de la partie de connexion du cordon de mesure de l'appareil de la figure 1,
- la figure 3 est un algorithme représentant la logique d'activation des moyens mesure,
- la figure 4 est un schéma de principe décrivant l'architecture générale de l'appareil, et
- la figure 5 est une vue de face schématique d'une partie de la façade d'un appareil multimètre de l'art antérieur.

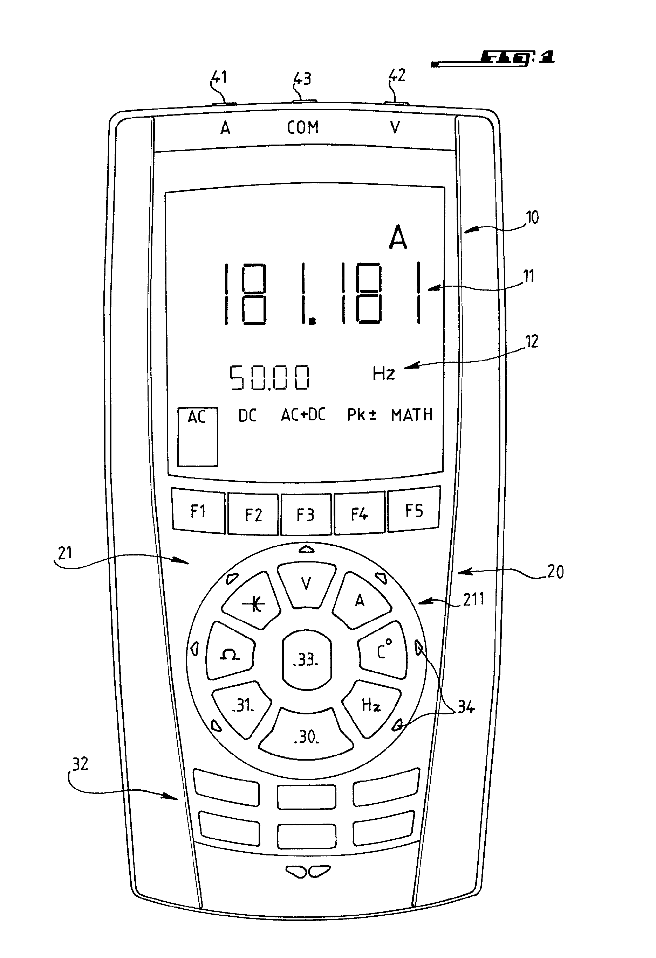

L'appareil multimètre de la figure 1 est adapté à la mesure d'une pluralité de grandeurs, qui sont dans le mode de réalisation de l'invention décrit ci-dessous réparties en six familles : l'intensité, la tension et la fréquence d'un courant électrique, la capacité et la résistance électrique d'un circuit électrique et la température.

Cet appareil comprend un écran d'affichage 10 des résultats de mesure, une pluralité de moyens de mesure 15, associés chacun à une grandeur prédéterminée, et un dispositif de sélection 20 de la grandeur à mesurer.

Selon l'invention, le dispositif de sélection 20 comprend des zones tactiles de sélection 21 de la grandeur à mesurer, et des moyens d'activation 22 des moyens de mesure associés à la grandeur sélectionnée à l'aide des zones tactiles de sélection 21.

Les zones tactiles de sélection 21 sont divisés en deux sous-ensembles : des zones tactiles de famille 211 et des zones tactiles menu F1 à F5.

Les zones tactiles de famille 211 permettent de sélectionner une des six familles de grandeurs mentionnées plus haut. Ces zones tactiles de famille 211 sont au nombre de six, et sont chacune associée à une famille de grandeur unique, telle que l'intensité A ou la tension V.

Les zones tactiles menus F1 à F5 permettent, entre autres, de sélectionner dans une même famille la grandeur à mesurer.

L'appareil comprend également une zone tactile de marche/arrêt de l'appareil 30 et une zone tactile 31 de paramétrage général de l'appareil, permettant par exemple de régler l'horloge interne.

Les six zones tactiles de famille 211, la zone tactile de marche/arrêt de l'appareil 30 et la zone tactile 31 de paramétrage général de l'appareil sont disposées en un cercle imitant un commutateur rotatif mécanique.

Les zones tactiles menu F1 à F5 sont disposées immédiatement sous l'écran d'affichage 10, et permettent, outre le rôle décrit ci-dessus, de faire varier le réglage des moyens de mesure sélectionnés à l'aide des zones tactiles de sélection 21.

La fonction de ces zones F1 à F5 varie suivant la famille de grandeurs sélectionnée à l'aide des zones tactiles de famille 211. Des indications sur la fonction de chaque zone tactile menu F1 à F5 sont généralement indiquées sur l'écran d'affichage 10, immédiatement en regard des zones tactiles menu F1 à F5.

Sur la figure 1, l'appareil est représenté dans un état où la famille de grandeurs à mesurer sélectionnée est l'intensité. On voit que, dans ce cas, la zone tactile F1 sert à sélectionner un mode de fonctionnement de l'appareil adapté à un courant alternatif, la zone F2 à un courant continu, la zone F3 à des courants mixtes continus et alternatifs, la zone F4 un mode de fonctionnement dans lequel l'appareil mesure le courant de crête, et la zone F5 donne accès à un menu de réglage de la mise à l'échelle des valeurs mesurées par modification du gain.

Dans le cas où la famille de grandeurs à mesurer sélectionnée est la tension, les zones tactiles menu F1 à F5 conservent les mêmes fonctions que dans le cas où l'intensité est mesurée.

Dans le cas où la famille de grandeurs à mesurer sélectionnée est la résistance, la zone tactile menu F1 sert à sélectionner la grandeur résistance électrique, la zone F2 à régler les sons émis par l'appareil, la zone F3 à sélectionner un mode de fonctionnement de l'appareil adapté au test de diodes, la zone F4 est inactive et la zone F5 donne accès à un menu de réglage de la mise à l'échelle.

Dans le cas où la famille de grandeurs à mesurer sélectionnée est la fréquence, la zone tactile menu F1 sert à sélectionner la grandeur fréquence, la zone F2 la grandeur période, la zone F3 la grandeur nombre d'impulsions, la zone F4 la grandeur temps et la zone F5 donne accès à un menu de réglage de la mise à l'échelle. La zone F4 donne en fait accès à un chronomètre.

Dans le cas où la famille de grandeurs à mesurer sélectionnée est la capacité, les zones F1 à F4 sont inactives, la zone F5 donnant accès à un menu de réglage de la mise à l'échelle.

Dans le cas où la famille de grandeurs à mesurer sélectionnée est la température, les zones F1 à F4 permettent de sélectionner des modes de fonctionnement de l'appareil adaptés à différents types de sondes de température, la zone F5 donnant accès à un menu de réglage de la mise à l'échelle.

Quand une zone tactile de famille 211 a été actionnée, l'appareil par défaut adopte la configuration accessible par la zone tactile F1.

L'appareil comprend encore des zones tactiles fonctionnelles 32 permettant d'activer des fonctions de l'appareils communes à tous les moyens de mesure 15.

Ces fonctions sont par exemple la gestion du calibre de mesure, la consultation des minima et maxima, l'affichage du résultat de la mesure non pas en valeur absolue mais en valeur relative par rapport à une référence, la mise en mémoire de valeurs instantanées ou encore la possibilité de figer l'écran à une valeur instantanée.

Le calibre de mesure est un ordre de grandeur prédéterminé, par exemple microampère, milliampère ou ampère pour une mesure d'intensité, permettant à l'appareil d'adopter un gain bien adapté à l'intensité du signal à mesurer.

Comme le montre la figure 1, l'écran d'affichage 10 comprend une zone d'affichage principale 11, dans laquelle s'affiche le résultat de la mesure, et une zone d'affichage secondaire 12, dans laquelle s'affiche un autre résultat sélectionné à l'aide d'une zone tactile 33 de gestion du contenu de l'affichage.

Cette zone tactile 33 de gestion du contenu de l'affichage est disposée au centre du cercle formé par les zones tactiles de famille 211, la zone tactile 31 de paramétrage général, et la zone tactile de marche/arrêt 30. Le paramètre secondaire affiché dans la zone d'affichage secondaire 12 de l'écran 10 peut être par exemple la fréquence du courant dans le cas de la mesure de l'intensité d'un courant alternatif.

Des indicateurs lumineux 34 sont disposés en cercle autour des zones tactiles de famille 211 et de la zone tactile 31 de paramétrage général.

Un indicateur lumineux 34 est associé à chacune des zones tactiles citées ci-dessus et est disposé à proximité immédiate de celle-ci.

Un indicateur lumineux 34 allumé indique soit la famille à laquelle appartient la grandeur mesurée couramment par l'appareil, cette famille étant celle de la zone tactile 211 auquel l'indicateur lumineux 34 est associé, soit que le menu de paramétrage général est en cours d'utilisation.

Les indicateurs lumineux 34 sont des diodes lumineuses, connues sous l'acronyme LEDS.

L'appareil comprend trois douilles d'entrée Ampère 41, Volt 42 et Commun 43 disposées sur un côté supérieur de l'appareil, et un cordon de mesure 44, raccordé électriquement par une extrémité de connexion 45 à la douille d'entrée Ampère 41 ou à la douille d'entrée Volt 42, en fonction de la grandeur à mesurer.

Le cordon de mesure 44 est raccordé électriquement par une extrémité de mesure opposée à son extrémité de connexion à une sonde de mesure ou à un point sur lequel on veut effectuer une mesure, par exemple un point d'un circuit électrique.

Un cordon de référence 46, électriquement conducteur, est raccordé électriquement par une extrémité à la douille d'entrée Commun 43, et par une extrémité opposée à un point de référence, par exemple la masse du circuit électrique sur lequel on veut faire la mesure.

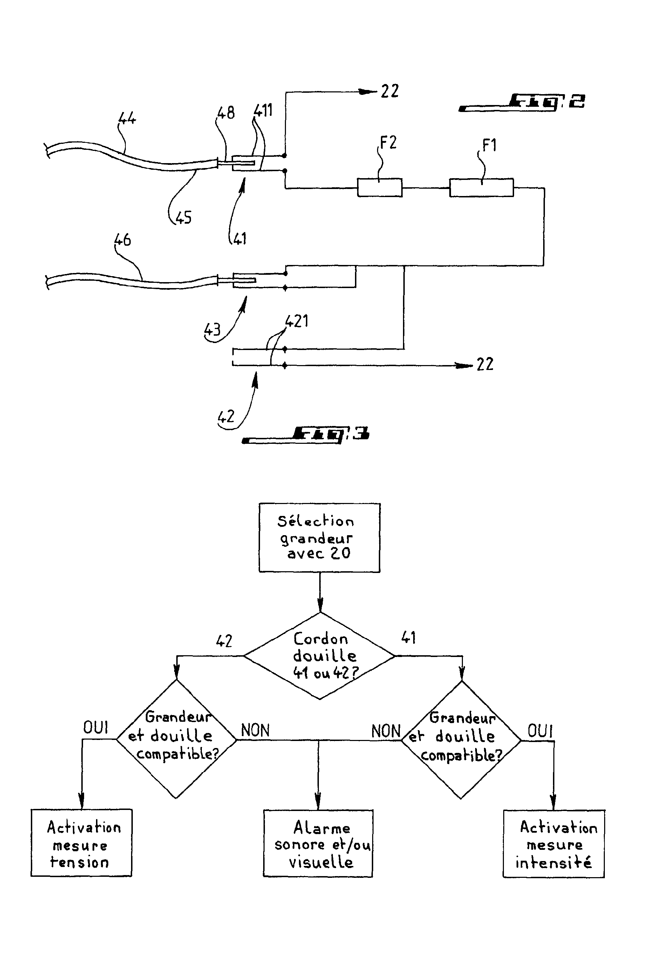

La structure générale de l'appareil est représentée sur la figure 4.

Les zones tactiles de famille 21, de marche/arrêt 30, de paramétrage général 31, menu F1 à F5, fonctionnelles 32 et de gestion du contenu de l'affichage 33 sont toutes des contacteurs, par exemple des boutons poussoirs, permettant de positionner des relais électromécaniques ou statiques qui leurs sont associés, ces relais étant portés par une carte électronique.

Les moyens d'activation 22 comprennent un microprocesseur 23 recevant les commandes venant des zones tactiles et un circuit de commutation électronique 24 comprenant des relais statiques et électromécaniques, reliant les douilles d'entrées 41 à 43 aux moyens de mesure 15. La configuration du circuit de commutation électronique 24 est pilotée par le microprocesseur 23 en fonction des commandes venant des zones tactiles.

Chaque bouton poussoir permet d'envoyer une commande au microprocesseur 50.

Les indicateurs lumineux 34 sont commandés par le microprocesseur 50, qui les allume et les éteints en fonction des signaux de commande reçus des moyens d'activation 22.

Le microprocesseur 50 assure également la gestion de l'écran d'affichage 10 et le choix automatique du calibre de mesure en fonction du signal d'entrée.

L'appareil comprend des moyens de détection de la connexion de l'extrémité de connexion 45 du cordon de mesure 44 à la douille d'entrée Ampère 41 ou à la douille d'entrée Volt 42.

A cet effet, les douilles d'entrée Ampère et Volt 41 et 42 comprennent chacune deux demi-douilles électriquement isolées l'une de l'autre, respectivement les demi-douilles Ampère 411 et Volts 421.

L'extrémité de connexion 45 du cordon de mesure est équipé d'une fiche 48 mettant les deux demi-douilles Ampère 411 en court-circuit quand l'extrémité de connexion 45 du cordon est connectée à la douille d'entrée Ampère 41, et mettant les deux demi-douilles Volt 421 en court-circuit quand l'extrémité de connexion 45 du cordon est connectée à la douille d'entrée Volt 42

Les moyens de détection détectent la mise en court-circuit des deux demi-douilles Ampère 411 ou Volt 412 en comparant les potentiels des demi-douilles d'une même douille.

Quand les potentiels des deux demi-douilles Ampère 411 sont égaux, le cordon est considéré présent dans la douille d'entrée Ampère 41. De même, quand les potentiels des deux demi-douilles Volt 421 sont égaux, le cordon est considéré présent dans la douille d'entrée Volt 42. Les moyens de détection envoient cette information au microprocesseur 23.

Comme le montre la figure 3, quand un utilisateur sélectionne une grandeur à mesurer à l'aide du dispositif de sélection 20, le microprocesseur 23 teste si le cordon de mesure 44 est présent dans la douille d'entrée Ampère 41 ou dans la douille d'entrée Volt 42.

Si la grandeur à mesurer sélectionnée est compatible avec le branchement du cordon de mesure 44, alors le microprocesseur 23 active les moyens de mesure correspondant.

Dans le cas contraire, l'appareil émet une alarme sonore et/ou visuelle.

En cours de mesure, le microprocesseur 23 teste périodiquement s'il y a toujours adéquation entre la position du cordon de mesure dans les douilles et la grandeur à mesurer sélectionnée.

Ainsi, les moyens de mesure de courant ne seront activés que si le cordon de mesure 44 est relié à la douille d'entrée Ampère 41, et si la grandeur sélectionnée est le courant. De même, les moyens de mesure de tension ne seront activés que si le cordon de mesure 44 est relié à la douille d'entrée Volt 42, et si la grandeur sélectionnée est la tension.

Cette fonctionnalité de l'appareil permet de s'affranchir d'une erreur de manipulation courante sur un multimètre, qui consiste à confondre tension et courant et à sélectionner le courant à l'aide du dispositif de sélection 20 alors que l'appareil est branché sur une source de tension. On risque alors de l'endommager gravement.

L'une des deux demi-douilles 411 de la douille d'entrée Ampère 41 est électriquement reliée à la douille d'entrée Commun 43 à travers un fusible principal F1 et un fusible secondaire F2 en série.

Le fusible principal F1 est un fusible de forte capacité, coupant à 1000 Volts et 11 Ampères. Ce fusible est coûteux et difficile à approvisionner.

Le fusible secondaire F2 est un fusible courant, peu coûteux, coupant à 10 Ampères environ et à une tension inférieure à la moitié de la tension à laquelle le fusible principal F1 coupe, par exemple 250 Volts.

Ce fusible secondaire F2, plus sensible que le fusible principal, protège celui-ci car il sera détruit avant le fusible principal F1 en cas de mauvaise manipulation de l'appareil.

Cette mauvaise manipulation peut par exemple consister à relier le cordon de mesure 44 à la douille d'entrée Ampère 41, et à brancher le cordon de mesure sur une source de tension importante. Le fusible F2 sera détruit, et le fusible F1 sera préservé.

Il est à noter que l'appareil ne possède qu'une seule douille d'entrée Ampère, ce qui permet de n'avoir qu'un seul jeu de fusibles et de gagner de la place.

On conçoit donc bien que l'appareil offre des avantages, tout en préservant l'aspect visuel auquel les utilisateurs sont habitués. Les zones tactiles forment en effet un cercle qui rappelle le sélecteur mécanique rotatif traditionnel, et permettent de sélectionner la famille de grandeur à mesurer, comme le sélecteur rotatif.

En revanche, l'appareil de l'invention présente l'avantage de pouvoir être complètement commandé à distance, ce qui permet de l'étalonner de façon automatique, sans actionneur mécanique.

La structure de l'appareil permet également de réaliser des scrutations automatiques, qui consistent à mesurer de façon cyclique des grandeurs différentes en passant de l'une à l'autre après une temporisation.

Enfin, il faut souligner que l'appareil permet un accès direct et rapide aux fonctions principales, ce qui n'est pas le cas des appareils de l'art antérieur.

La figure 5 représente une partie de la façade d'un appareil de mesure de l'art antérieur équipé d'un sélecteur mécanique rotatif 70 et de deux boutons de sélection 71 et 72.

Le sélecteur 70 peut adopter douze positions numérotées de 1 à 12 sur la figure 5, accessibles à partir de la position 1 en tournant le sélecteur dans un sens prédéterminé, représenté par une flèche. L'appareil est à l'arrêt quand le sélecteur est en position 1.

Le tableau 1 compare le nombre d'actions nécessaires, dans le cas de l'appareil de l'invention et dans le cas de l'appareil de la figure 5, pour sélectionner une grandeur mesurée et ajuster les principaux paramètres associés à cette grandeur, comme par exemple le type de courant (alternatif ou continu) pour les mesures d'intensité ou le calibre de mesure. Une action consiste à appuyer sur une zone tactile dans le cas de l'invention et à tourner le sélecteur d'une position ou à appuyer sur un bouton dans le cas de l'appareil de la figure 5.

Ce tableau met en évidence qu'il faut en moyenne deux actions pour réaliser ces opérations avec l'appareil de l'invention, et 6,4 avec l'appareil de la figure 5. L'appareil de l'invention est donc beaucoup plus agréable et convivial à employer.

**Tableau 1**

| Grandeur | Paramètres | Appareil de l'invention | | Art antérieur | Ecart en nombres d'actions |
|---|---|---|---|---|---|
| | | Zone 211 | Zone Menu | Nbre de positions | |
| Tension | Gamme V dc | 1 appui | 1 appui F2 | 3 | 1 |
| | Gamme mV, dc | 1 appui | 1 appui F2 | 4 | 2 |
| | Gamme V, ac | 1 appui | - | 1 | 0 |
| | Gamme mV, ac | 1 appui | - | 2 | 1 |
| | Gamme V, ac+dc | 1 appui | 1 appui F3 | 3 + bouton 71 | 2 |
| | Gamme mV, ac+dc | 1 appui | 1 appui F3 | 4 + bouton 71 | 3 |
| Résistance | | 1 appui | - | 5 | 4 |
| Capacité | | 1 appui | - | 6 | 5 |
| Test diode | | 1 appui | 1 appui F3 | 6 + bouton 71 | 5 |
| Fréquence | | 1 appui | - | 3 + bouton 72 | 3 |
| Intensité | Gamme A ac | 1 appui | - | 8 | 7 |
| | Gamme µA ac | 1 appui | - | 9 | 8 |
| | Gamme A dc | 1 appui | 1 appui F2 | 10 | 8 |
| | Gamme µA dc | 1 appui | 1 appui F2 | 11 | 9 |
| | Gamme A ac+dc | 1 appui | 1 appui F3 | 10 + bouton 71 | 9 |
| | Gamme µA ac+dc | 1 appui | 1 appui F3 | 11 + bouton 71 | 10 |

Un autre avantage de l'appareil est qu'il ne comprend pas de pièces mobiles telles qu'un sélecteur rotatif ni de pièces en frottement, et qu'il s'use donc très lentement. Sa fiabilité est donc très grande.

Enfin, l'utilisation du dispositif de sélection ne nécessite qu'une seule main, car il suffit d'appuyer sur les zones tactiles avec un doigt. Ce mode de fonctionnement est facile et rapide. L'appareil est de préférence portatif, mais peut être fixe. Ses dimensions sont comparables à celles d'un multimètre portable utilisé de façon classique pour contrôler des circuits électriques et équipé d'un sélecteur mécanique rotatif.

## Revendications

1. Appareil multimètre de mesure d'une pluralité de grandeurs, telles que l'intensité ou la tension d'un courant électrique ou la résistance électrique d'un circuit, l'appareil comprenant une pluralité de moyens de mesure (15) associés chacun à une grandeur prédéterminée, et un dispositif de sélection (20) de la grandeur à mesurer, **caractérisé en ce que** le dispositif de sélection (20) comprend des zones tactiles (21) de sélection de la grandeur à mesurer, et des moyens d'activation (22) des moyens de mesure (15) associés à la grandeur sélectionnée à l'aide des zones tactiles de sélection (21).

2. Appareil selon la revendication 1, **caractérisé en ce que** les moyens d'activation (22) comprennent un microprocesseur (23), chaque zone tactile de sélection (21) positionnant un relais statique ou électromécanique pour agir sur le microprocesseur (23).

3. Appareil selon la revendication 2, **caractérisé en ce qu'**il comprend une pluralité de douilles d'entrée, les moyens d'activation (22) comprenant un circuit de commutation (24) reliant les douilles d'entrée au moyens de mesure (15) et dont la configuration est pilotée par le microprocesseur (23) en fonction des commandes des zones tactiles de sélection (21).

4. Appareil selon l'une quelconque des revendications 1 à 3, **caractérisé en ce que** les grandeurs sont subdivisées en plusieurs familles, les zones tactiles de sélection (21) comprenant des zones tactiles de famille (211) permettant de sélectionner une famille de grandeurs, et des zones tactiles menu (F1 à F5) permettant de sélectionner une grandeur au sein d'une famille.

5. Appareil selon l'une quelconque des revendications 1 à 4, **caractérisé en ce qu'**il comprend des moyens de mesure de l'intensité électrique, une douille d'entrée Ampère (41) utilisée au moins quand les moyens de mesure d'intensité sont sélectionnés, un cordon de mesure (44) sélectivement connecté par une extrémité de connexion (45) à l'une des douilles, et des moyens de détection de la connexion de l'extrémité de connexion (45) du cordon à la douille d'entrée Ampère (41).

6. Appareil selon la revendication 5, **caractérisé en ce que** la douille d'entrée Ampère (41) comprend deux demi-douilles (411) électriquement isolées l'une de l'autre, l'extrémité de connexion (45) du cordon étant équipé d'une fiche (48) mettant les deux demi-douilles (411) en court-circuit quand l'extrêmité de connexion (45) du cordon est connectée à la douille d'entrée Ampère (41), les moyens de détection détectant la mise en court-circuit des deux demi-douilles (411).

7. Appareil selon l'une quelconque des revendications 5 ou 6, **caractérisé en ce que** les moyens d'activation (22) activent automatiquement les moyens de mesure de l'intensité à la condition que les moyens de détection détectent la connexion de l'extrémité de connexion (45) du cordon à la douille d'entrée Ampère (411) et que l'intensité ait été sélectionnée à l'aide du dispositif de sélection (20) de la grandeur à mesurer.

8. Appareil selon l'une quelconque des revendications 6 à 7, **caractérisé en ce qu'**une des deux demi-douilles (411) de la douille d'entrée Ampère (41) est électriquement reliée à une douille d'entrée de référence à travers un fusible principal (F1) et un fusible secondaire (F2) en série, le fusible secondaire (F2) se détruisant à une tension au moins deux fois plus faible que le fusible principal (F1).

9. Appareil selon l'une quelconque des revendications 1 à 8 combinée avec la revendication 4, **caractérisé en ce que** les zones tactiles de famille (211) sont disposées sur un cercle.

10. Appareil selon la revendication 9, **caractérisé en ce qu'**il comprend des indicateurs lumineux (34), disposés en cercle à proximité des zones tactiles de famille (211), indiquant à quelle famille appartient le moyen de mesure actif.
